**Europäisches Patentamt**

**European Patent Office**

**Office européen des brevets**

(19)

(11) Veröffentlichungsnummer : **0 005 727**
**B1**

(12) **EUROPÄISCHE PATENTSCHRIFT**

(45) Veröffentlichungstag der Patentschrift :
**21.01.81**

(51) Int. Cl.³ : **G 01 R   1/073**, G 05 D   3/20

(21) Anmeldenummer : **79101266.9**

(22) Anmeldetag : **26.04.79**

(54) **Abfühlvorrichtung zum Feststellen des Ortes von elektrisch leitenden Punkten.**

(30) Priorität : **30.05.78 US 910253**

(43) Veröffentlichungstag der Anmeldung :
**12.12.79 (Patentblatt 79/25)**

(45) Bekanntmachung des Hinweises auf die Patenterteilung : **21.01.81 Patentblatt 81/03**

(84) Benannte Vertragsstaaten :
**DE FR GB**

(56) Entgegenhaltungen :
**US - A - 806 800**
**IBM TECHNICAL DISCLOSURE BULLETIN,**
**Vol. 12, Nr. 4, September 1969**
**New York, U.S.A.**
**A. W. TILL : « Column Contact Probe »,**
**Seite 551**

(73) Patentinhaber : **International Business Machines Corporation**

**Armonk, N.Y. 10504 (US)**

(72) Erfinder : **Faure, Louis Henry**
**24 King Drive**
**Poughkeepsie, NY 12603 (US)**
Erfinder : **Hodge, Philo Burton**
**Garnet Road**
**Roxbury Connecticut 06783 (US)**

(74) Vertreter : **Böhmer, Hans Erich, Dipl.-Ing.**
**Schönaicher Strasse 220**
**D-7030 Bblingen (DE)**

Imprimerie Jouve, 17, rue du Louvre, 75001 Paris, France

## Abfühlvorrichtung zum Feststellen des Ortes von elektrisch leitenden Punkten

Die Erfindung betrifft eine Vorrichtung zum Prüfen von elektrischen Elementen und insbesondere eine Abfühlvorrichtung zur genauen Bestimmung des Ortes von leitenden Punkten auf einem Substrat und insbesondere eine Abfühlvorrichtung zum Bestimmen des genauen Ortes in X- und Y-Koordinaten einer Gruppe von elektrisch leitenden Punkten auf der Oberfläche eines isolierenden Substrats.

Zu diesem Zweck soll die Abfühlvorrichtung einen Abtastkopf mit Abtastsonden aufweisen, die aus einer Anzahl langgestreckter, flacher, biegsamer, bandförmiger Elemente bestehen, deren Dicke jeweils wesentlich kleiner ist als die Breite des zu ermittelnden leitenden Punktes, wobei dieser Abtastkopf zur genauen Bestimmung des Ortes des leitenden Punktes auf das Substrat abgesenkt werden kann.

Während der letzten Jahre verlief die Entwicklung immer mehr in Richtung auf eine sehr hohe Integrationsdichte in integrierten Schaltungen mit unterschiedlichen aktiven und passiven Schaltkreisen auf einem einzigen Halbleiterplättchen. Gleichzeitig damit nahm auch die Möglichkeit zu, vollständige Datenverarbeitungsanlagen auf Substraten unterzubringen, die beispielsweise unmittelbar auf einer Grundplatte befestigt werden können und praktisch die gesamte Schaltung der Maschine darstellen können. In diesen Fällen kann das Substrat relativ groß sein und kann beispielsweise mehrere Orte für hochintegrierte Halbleiterplättchen oder Punkte enthalten, an denen solche hochintegrierten Halbleiterplättchen befestigt werden können. Diese Stellen, die die Halbleiterplättchen miteinander verbinden, können je nach der Konstruktion der Maschine entweder durch offene Verdrahtung oder im Fall von mehrschichtigen keramischen Substraten über eine oder mehrere Metallisierungsschichten der mehrschichtigen Keramik durch entsprechende Verbindungen angeschlossen werden. Unabhängig von der Zusammensetzung der Substrate, d. h. unabhängig davon, ob sie aus keramischem Material, Epoxydharz oder einem anderen Material bestehen, enthält jeder Ort für ein Halbleiterplättchen eine Anzahl von Kontakten auf den Substraten, die auf ihre elektrische Verbindung mit anderen Orten von Halbleiterplättchen, auf Durchgang oder Unterbrechung geprüft werden müssen. Das hat bei der automatischen Prüfung von passiven Schaltungen zu Schwierigkeiten gefürt. Die bezüglich der Abmessungen auftretenden Schwierigkeiten, d. h. beispielsweise das Schrumpfen oder Ausdehnen der Substrate macht es sehr schwierig, mit den Prüfspitzen einen Kontakt zu den auf dem Substrat in einem Muster angeordneten Kontaktanschlüssen herzustellen.

Komplizierte mehrschichtige keramische Halbleiterpackungen können beispielsweise dadurch hergestellt werden, daß man grüne keramische Folien durch Aufstreichen und Trocknen einer Trübe herstellt, die fein verteiltes keramisches Material, organische Bindemittel, Lösungsmittel und einen Weichmacher enthält. Diese keramischen Folien werden zur Herstellung von durchgehenden Bohrungen gelocht und in einem Siebdruckverfahren wird eine elektrisch leitende Paste zur Ausfüllen der Bohrungen und zur Herstellung von Leitungsmustern aufgebracht. Dann werden die Folien übereinander gestapelt und das Ganze wird zur Bildung eines einstückigen keramischen Substrats mit innen liegenden Leitungszügen gesintert. Auf diese Weise lassen sich sehr komplizierte und gedrängt angeordnete Schaltungen herstellen, so daß es dadurch möglich ist, auf einem einzigen Substrat eine größere Menge hochintegrierter Halbleiterschaltungen anzubringen. Es ist dabei zweckmäßig, die Halbleiterschaltungen auf der Oberseite des Substrats anzulöten. Die integrierten Schaltungen, deren Anzahl bis zu 100 oder mehr betragen kann, werden auf Lötstützpunkten befestigt, die ihrerseits mit der innen liegenden Metallisierung und den Anschlußstiften auf der Unterseite des Substrats verbunden sind.

Während des Sintervorgangs schrumpfen mehrschichtige keramische Substrate um etwa 15 bis 20 %. Häufig ist dabei diese Schrumpfung nicht genau gleichförmig, so daß das gesamte Muster von Lötstützpunkten auf der Oberfläche verzerrt wird. Diese Verzerrung des Musters and Lötstützpunkten verursacht dann Schwierigkeiten, wenn wegen der notwendigen Durchprüfung des Substrats elektrischer Kontakt mit den einzelnen Lötpunkten hergestellt werden muß. Eine mögliche Lösung dür diese Schwierigkeit findet sich in der Deutschen Patentanmeldung P 27 24 479.7, bei der eine Sonde offenbart ist, die aus mehreren Abschnitten besteht, wobei die einzelnen Abschnitte zueinander beweglich sind, so daß eine lineare Verzerrung des Substrats und des Musters an Lötstützpunkten ausgeglichen werden kann. Diese Sonde ist jedoch ziemlich teuer und muß eigens für ein bestimmtes Substrat entworfen werden. Außerdem läßt sich diese Sonde nur für eine lineare, gleichförmige Verzerrung einsetzen. Wenn beispielsweise eine Seite eines mehrschichtigen keramischen Substrats stärker geschrumpft ist als die andere Seite, dann erhält man eine Drehung von einzelnen Abschnitten des Lötstützpunktmusters. Bei dieser Sonde ist eine teilweise Drehung der Sondenabschnitte für eine derartige Verzerrung des Lötstützpunktmusters nicht möglich.

Ein weiterer Vorschlag zum Prüfen einer komplizierten Leitungsführung in dem Substrat besteht darin, die Kontaktsonden systematisch schrittweise in der Weise weiterzubewegen, daß sie nur einen Teil des Lötstützpunktmusters berühren, d. h. beispielsweise das Lötstützpunktmuster für eine einzige Schaltung und dies über das gesamte Lötstützpunktmuster. Die schrittweise Fortschaltung der Sonde wird solange fortgesetzt, bis alle Kombinationen von Mustersegmenten und die zugehörigen innen liegenden Leitungsverbindungen überprüft sind.

Die Durchführung der schrittweisen Fortschaltung der Sonde sowie die Verwendung der aus einzelnen Segmenten bestehenden Sonde benötigen Information über den Ort einer jeden Gruppe von Lötstützpunkten, die durch die Sonde erfaßt werden müssen, so daß die Sonde tatsächlich die Lötstützpunkte berührt und nicht verfehlt. Ein Verfahren zur Feststellung dieser Art von Information ist in der Deutsche Patentanmeldung P 27 44 299.5 enthalten.

Die Erfindung wird nunmehr anhand eines Ausführungsbeispiels in Verbindung mit den beigefügten Zeichnungen im einzelnen beschrieben.

In den Zeichnungen zeigt

Fig. 1 eine isometrische Ansicht teilweise als abgebrochene Schnittansicht der Gesamtvorrichtung zur Bestimmung des Koordinatenortes einer Gruppe von Anschlußkontakten auf einem Substrat,

Fig. 2 eine Draufsicht, teilweise abgebrochen, der in Fig. 1 dargestellten Vorrichtung, längs der Linie 2-2,

Fig. 2A eine Draufsicht im Querschnitt im vergrößertem Maßstab durch die Sonde zur Darstellung der verschiedenen Berührungspunkte bei Feststellung eines Lötstützpunktes oder Kontaktes,

Fig. 2B eine Seitenansicht längs der Linie 2B-2B in Fig. 2A,

Fig. 3 eine isometrische Ansicht eines Blattfederelements der in der erfindungsgemäß aufgebauten Vorrichtung verwendeten Abtastsonde,

Fig. 4 eine isometrische Ansicht zur Darstellung des Aufbaus der Abtastsonde gemäß der Erfindung und

Fig. 4A eine Seitenansicht im vergrößerten Maßstab zur Darstellung der Konstruktion, die eine erhöhte Krümmung der Blattfederelemente der Abtastsonden liefert.

## Einzelbeschreibung der Erfindung

In den Zeichnungen ist eine bevorzugte Ausführungsform der erfindungsgemäß aufgebauten Vorrichtung zur Bestimmung des Ortes von elektrisch leitenden Kontaktpunkten auf der Oberfläche eines Substrats gezeigt. In den Zeichnungen sind die verschiedenen Teile nicht notwendigerweise maßstabsgerecht dargestellt. Einige der Abmessungen sind übertrieben groß gezeichnet, was der Vereinfachung der Erläuterung und der klareren Darstellung des hier verwendeten Erfindungsprinzips dient.

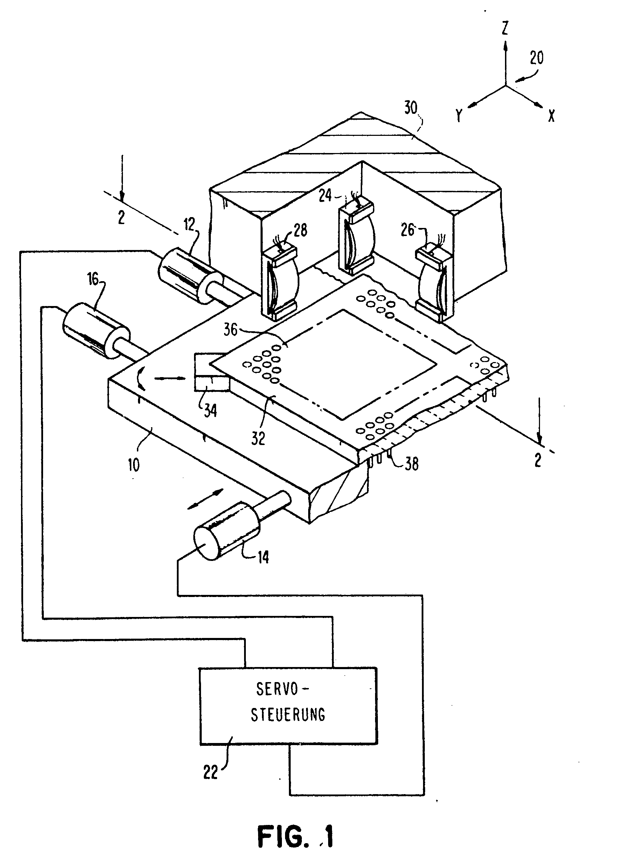

In Fig. 1 ist das Gesamtsystem dargestellt, das einen ein Substrat tragenden Tisch 10 aufweist, der auf einer Bank oder einer ähnlichen Vorrichtung verschiebbar gelagert ist. Die genaue Position des Tisches 10 wird durch eine Servosteuerung gesteuert, die einen Servomotor 12 für eine Bewegung des Tisches in X-Richtung, einen zweiten Servomotor 14 für die Bewegung des Tisches in Y-Richtung und einen dritten Servomotor 16 für eine Drehbewegung des Tisches 10 enthält.

Die X-, Y- und Z-Richtung der in Fig. 1 gezeigten Vorrichtung wird durch die X-, Y- und Z-Pfeile 20 in Fig. 1 dargestellt. Die Servosteuerung kann dabei die Servomotoren 12, 14 und 16 ansteuern. Die Servosteuerung ihrerseits ist programmgesteuert, wobei der Tisch schrittweise in die einzelnen Positionen weitergeschaltet werden kann, so daß der Tisch durch die Abtastsonden 24, 26 und 28 abgetastet werden kann, die auf einem Abtastkopf 30 angeordnet sind. Ein Substrat 32, beispielsweise ein mehrschichtiges keramisches Substrat wird auf dem Tisch 10, beispielsweise durch eine bewegliche Klammer 34 festgehalten. Die Klammer 34 wirkt dabei entweder in Verbindung mit einer zweiten Klammer (night gezeigt) mit einem Anschlag auf der gegenüberliegenden Seite des Substrats (nicht gezeigt) oder anderen geeigneten Anschlägen zusammen. Auf der Oberseite des Substrats 32 ist eine Anzahl von Mustern 36 von aus leitendem Material bestehenden Kontakten oder Lötstützpunkten vorgesehen. Im allgemeinen werden diese Muster von Anschlüssen oder Lötstützpunkten anschließend mit einer integrierten Schaltung durch Wiederaufschmelzlöten verbunden. Auf dem Substrat kann eine beliebige Anzahl, die 100 überschreiten kann, von aus Lötstützpunkten oder Anschlüssen bestehenden Mustern 36 vorhanden sein. Die Muster 36 sind normalerweise gleichartig angeordnet und sind mit Anschlußstiften 38 auf der Unterseite des Substrats 32 verbunden.

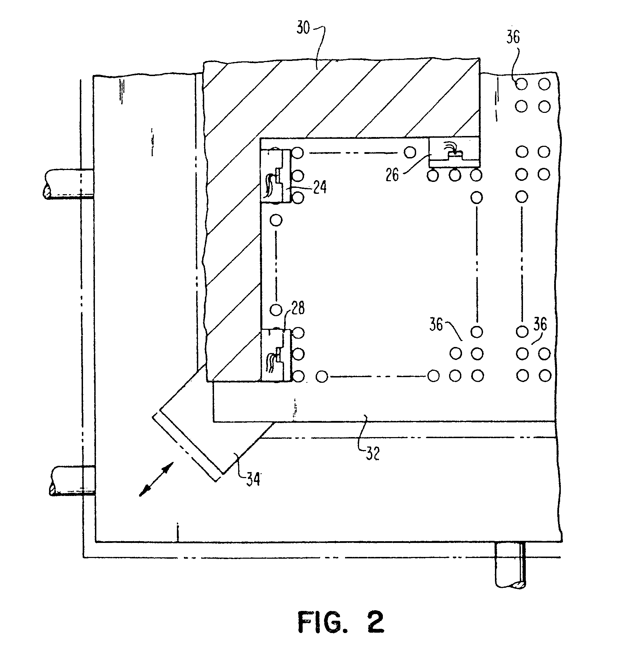

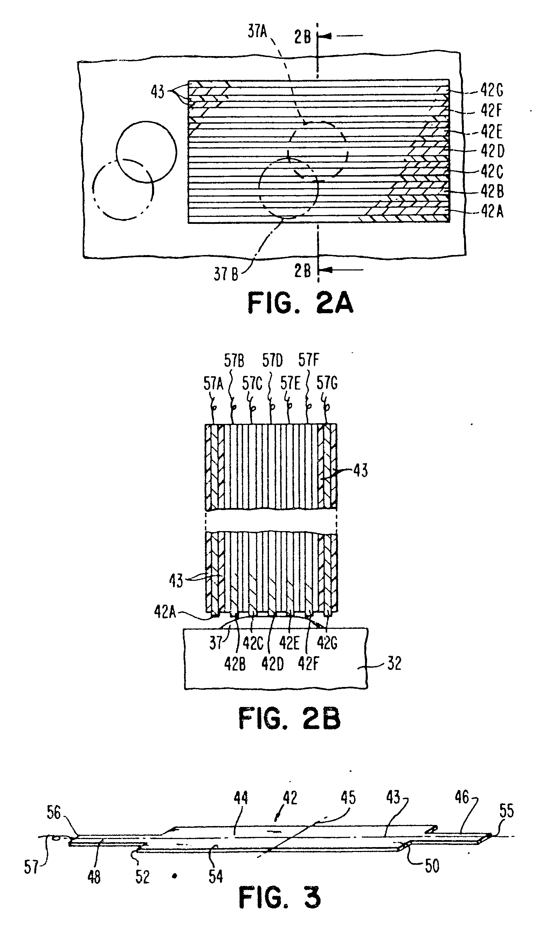

Die in Fig. 1 und 2 dargestellte Ausführungsform der Erfindung dient dazu, den genauen Ort eines jeden Musters 36 aus Anschlußkontakten oder Lötstützpunkten auf dem Substrat festzustellen, wobei ausgewählte einzelne Anschlußkontakte oder Lötstützpunkte als Bezugspunkte dienen. Die auf dem Abtastkopf 30 befestigten Abtastsonden 24, 26 und 28 lassen sich in Z-Richtung in Eingriff oder außer Eingriff mit den Mustern 36 aus Anschlußkontakten oder Lötstützpunkten auf dem Substrat 32 bewegen. Die Position des Substrats 32 kann mit Hilfe der Servosteuerung 22 in der Weise eingestellt werden, daß andere auf dem substrat befindliche Muster 36 von Anschlußkontakten oder Lötstützpunkten sich unter dem Abtastkopf befinden. Wenn der Abtastkopf für eine Berührung der Abtastsonden mit den Mustern aus Anschlußkontakten oder Lötstützpunkten nach unten bewegt wird, dann liefern die Abtastsonden eine genaue Anzeige für den Ort der Bezugspunkte auf dem Muster 36, wobei diese Kontaktberührung anschließend zur Herstellung einer elektrisch leitenden Verbindung mit den Anschlußkontakten oder Lötzstützpunkten durch eine Abtastsonde verwendet werden kann, so daß die zur Überprüfung der innen liegenden Leitungsverbindung des Substrats erforderlichen Prüfungen durchgeführt werden können. Diese Information wird dann abgespeichert und kann zu einem späteren Zeitpunkt verwendet werden.

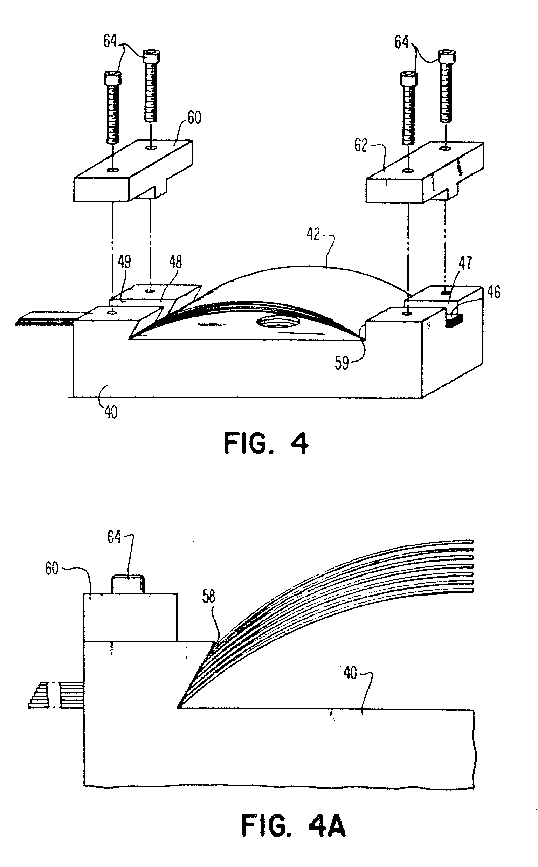

In Fig. 4 ist die Konstruktion der einzelnen Abtastsonden 24, 26 und 28 dargestellt. Die Abtastsonde besteht aus einer Grundplatte 40, in die eine Anzahl von Blattfederelementen 42 im gebogenen Zustand eingespannt werden Kann. Das in Fig. 3 gezeigte Blattfederelement 42 weist einen Mittelabschnitt 44, einen Kontaktabschnitt 46 und ein Anschlußteil 48 auf. An jeder Seite des Mittelabschnitts 44 sind Anschlagflächen 50 bzw. 52 vorgesehen. Das Blattfederelement 42 hat eine Hauptachse 43 und eine Nebenachse 45. Die Blattfederelemente 42 sind auf ihrer Oberfläche mit Ausnahme der Kontaktfläche 55 und des Teils 56, der an einer Leitung 57 angeschlossen werden soll, mit einem Überzug 54 aus einem dielektrischen Material, vorzugsweise aus Tetrafluoraethylen überzogen. Die Blattfederelemente 42 sind relativ dünn, so daß mindestens zwei von ihnen den Anschlußkontakt oder den Lötzstützpunkt berühren werden. Die Dicke der Blattfederelemente liegt dabei im Bereich zwischen 0,03 und 0,08 mm, während die Dicke des isolierenden Überzugs 54 im Bereich 0,03 und 0,013 mm liegt. Wie in Fig. 4 gezeigt, sitzen die Blattfederelemente 42 derart auf der Grundplatte 40 auf, daß der Mittelabschnitt, wie gezeigt, nach oben gekrümmt ist, während die Endabschnitte 46 und 48 in einer Nut 47 bzw. 49 liegen. Wie in Fig. 4 gezeigt, ist jedes der Blattfederelemente fortlaufend etwas mehr gekrümmt als das vorhergehende. Diese fortlaufend stärkere Krümmung der Blattfederelemente wird dadurch erreicht, daß eine nach innen geneigte Anschlagfläche 58 vorgesehen ist, mit der die Anschlagfläche 52 der Blattfederelemente 42 in Eingriff kommt. Wenn dann auf der Grundplatte 40 zusätzliche Blattderelemente 42 aufgestapelt werden, dann nimmt der Abstand zwischen den Anschlagflächen 58 und 59 fortlaufend ab, wodurch sich eine fortlaufend geringfügig stärkere Krümmung der einzelnen Blattfederelemente ergibt. Nachdem die erforderliche Anzahl von Blattfederelementen auf der Grundplatte 40 aufgestapelt ist, werden Klemmbacken 60 und 62 in die Nut 49 bzw. 47 eingesetzt und mit Schrauben 64 festgeschraubt, wodurch die einzelnen Blattfederelemente festgelegt sind, wobei aber gleichzeitig eine gewisse Beweglichkeit durch Gleiten in Längsrichtung für die Abschnitte 55 der Blattfederelemente 42 sichergestellt ist.

Die Blattfederelemente der Abtastsonde sind in der in Fig. 4 gezeigten Weise gekrümmt, damit eine begrenzte Beweglichkeit der Kontaktabschnitte 46 der einzelnen Blattfederelemente möglich ist. Damit ist eine begrenzte Anpassung an eine unregelmäßige Oberfläche möglich. Wie beispielsweise aus Fig. 2 zu sehen, berühren die Blattfederelemente 42C, 42D und 42E den Anschlußkontakt 37. Wenn das Blattfederelement 42D, das die Kuppe des Anschlußkontaktes 37 berührt, starr wäre, dann würde es dadurch nicht möglich sein, daß die beiden anderen zu beiden Seiten liegenden Blattfederelemente den Anschlußkontakt berühren. Weiterhin erhält man durch die fortschreitend stärkere Krümmung der einzelnen Elemente durch die abgeschrägte Oberfläche 58 in Fig. 4 eine gewisse Biegsamkeit für die dazwischen liegenden Blattfederelemente selbst dann, wenn die benachbarten Blattfederelemente sich in ihrer ursprünglichen gestreckten Lage befinden.

Eine andere Ausführungsform einer Abtastsonde, die jedoch nicht gezeigt ist, könnte beispielsweise aus einer Anzahl gegeneinander durch einen dünnen isolierenden Überzug isolierter Blattfederelemente bestehen, die einzeln einseitig eingespannt sind. Die einseitig eingespannten Blattfederelemente sind dabei dünne L-förmig abgebogene Blattfedern, die so eingespannt sind, daß jede zur Anpassung an einen Anschlußkontakt erforderliche Auslenkung durch eine leichte Verbiegung des Schenkels des eingespannten Blattfederelements aufgenommen wird. Die langen oder großen Abschnitte der Blattfederelemente werden dabei eng aneinander liegend parallel zueinander gehalten, entsprechend den Endabschnitten 46 der Blattfederelemente 42. Dabei können die einzelnen aufeinander folgenden Blattfederelemente jeweils mit einem etwas längeren Schenkel versehen sein, so daß sich ein geringfügiger Abstand ergibt, der für eine Auslenkung einzelner der Blattfederelemente ausreicht. Die Schenkelabschnitte sind dabei in geeigneter Weise festgelegt, so daß die Endabschnitte der Blattfederelemente, die einen Anschlußkontakt oder dergleichen abfühlen, in einer Ebene parallel zur Ebene der Oberseite des zu untersuchenden und zu prüfenden Substrats angeordnet sind.

Im Betrieb wird der Abfühlvorgang der Abfühlvorrichtung gemäß Fig. 1 dadurch eingeleitet, daß der Abtastkopf 30 über dem Substrat 32 abgesenkt wird, das ein Muster 36 aus Anschlußkontakten oder Lötstützpunkten enthält. Die Abtastsonden 24, 26 und 28 sind auf dem Abtastkopf 30 angeordnet und sollen vorbestimmte Anschlußkontakte des Musters feststellen, die als Bezugspunkte bei der Bestimmung des exakten Ortes der Muster von Anschlußkontakten benutzt werden sollen. Das Substrat 32 wird unterhalb der Abtastkopfes 30 angenähert an den gewünschten Ort angebracht, so daß die Abtastsonden die als Bezugspunkte dienenden Anschlußkontakte berühren. Wenn die Blattfederelemente 42A bis 42G der Abtastsonde in die Nähe der Oberfläche des Substrats 32 kommen, dann werden die Anschlußkontakte 37, die normalerweise geringfügig über die Oberfläche des Substrats hinausragen, durch zwei oder mehr Blattfederelemente 42 berührt. Wie in Fig. 2B gezeigt, berühren die Blattfederelemente 42C, 42D und 42E den Anschlußkontakt 37, wodurch diese drei Blattfederelemente miteinander kurzgeschlossen werden. Dies läßt sich durch eine entsprechende Schaltung, die hier nicht gezeigt ist, feststellen, da die Blattfederelemente mit Anschlußleitungen 57A bis 57G versehen sind, die an dieser Schaltung angeschlossen sind. Welche Blattfederelemente kurzgeschlossen werden, hängt natürlich vom Ort des Anschlußkontaktes 37 ab. Beispielsweise ist in Fig. 2A ein Anschlußkontakt 37A gezeigt, der die Blattfederelemente 42C, 42D und 42E kurzschließt. Dagegen schließt der Anschlußkontakt 37B in der dargestellten Position die Blattfederelemente 42A, 42B und 42C kurz. Die Größe der Anschlußkontakte und die Dicke oder Stärke der Blattfederelemente bestimmt dabei die Anzahl der Blattfederelemente, die durch einen Anschlußkontakt kurzgeschlossen werden. Der Ort und die Anzahl der gemeinsam kurzgeschlossenen Blattfederelemente werden festgestellt, und diese Information wird entweder von Hand oder über ein Programm durch eine Datenverarbeitungsanlage aufgezeichnet.

In Fig. 1 kann die Abtastsonde 24 den genauen Ort eines Musters von Anschlußkontakten in bezug auf die X-Richtung feststellen, die Abtastsonde 26 bestimmt dann den genauen Ort eines Musters von Anschlußkontakten in Y-Richtung, und die Abtastsonde 28 dient in Verbindung mit der Abtastsonde 24 der Feststellung der Winkellage des Musters von Anschlußkontakten. Bei der Abtastsonde 24 sind die Blattfederelemente 42 so angeordnet, daß die Nebenachse 45 senkrecht zur X-Richtung verläuft. Bei der Abtastsonde 26 sind die Blattfederelemente 42 so angeordnet, daß ihre Nebenachse 45 senkrecht zur Y-Richtung verläuft. Die Abtastsonde 28 ist derart angeordnet, daß ihre Blattfederelemente 42 senkrecht zur X-Richtung liegen. Die durch die kurzgeschlossenen Blattfederelemente ermittelte Information ermöglicht in Verbindung mit dem Bezugspunkt der Abtastsonde eine genaue Bestimmung des Ortes eines Musters von Anschlußkontakten auf dem Substrat mit nur einem Durchlauf. Anschließend wird das Substrat verschoben und der Abtastkopf 30 wird erneut über ein zweites Muster 36 von Anschlußkontakten nach unten bewegt, worauf der Vorgang wiederholt wird. Auf diese Weise kann Information über den genauen Ort aller Muster von Anschlußkontakten oder Lötstützpunkten auf dem Substrat erhalten werden. Falls erwünscht, können die Orte von auf Abstand liegenden Mustern von Anschlußkontakten ermittelt werden, und der Ort der dazwischenliegenden Muster von Anschlußkontakten kann auf der Grundlage der genau bestimmten Orte der Muster durch Interpolation angenähert werden. Nachdem das Substrat 32 durch die zuvor beschriebenen Abtastsonden abgefühlt worden ist, kann der Abtastkopf 30 abgehoben werden, worauf Prüfspitzen eine elektrisch leitende Verbindung nach den einzelnen aus Anschlußkontakten bestehenden Mustern herstellen können, mit einer schrittweisen Bewegung über das Substrat zur Durchführung der notwendigen Prüfungen. Die Servomotoren 12, 14 und 16 können zum Antrieb des das Substrat 32 tragenden Tisches 10 und zur Einstellung des Tisches in bezug auf die Prüfspitze benutzt werden, so daß mit jedem Anschlußkontakt eine elektrisch leitende Verbindung hergestellt wird.

Wie zuvor erwähnt, wird das Substrat 32 zunächst unterhalb des Abtastkopfes angeordnet, so daß die Wahrscheinlichkeit hoch ist, daß die Abtastsonden 24, 26 und 28 mit den richtigen Bezugspunkten der Muster 36 in Kontakt kommen. Man kann jedoch durch entsprechende Programmierung der die Prüfvorrichtung antreibenden Datenverarbeitungsanlage feststellen, wenn die falschen Bezugspunkte unter den Abtastsonden liegen, was der Fall sein kann, wenn die Verzerrung außergewöhnlich hoch ist. Wenn beispielsweise die Bezugspunkte in der äußeren Reihe liegen und die Abtastsonden in einer Richtung das Muster nicht finden, so daß Abtastsonden außerhalb des Musters liegen, so läßt sich dieser Zustand feststellen und die entsprechenden Korrekturen können durchgefürt werden. Wenn das gleiche Substrat sowohl für die Prüfung als auch für die Bestimmung des Ortes der Muster von Anschlußkontakten verwendet wird, dann werden entsprechende Kontaktverbindungen nach den Anschlußstiften 38 auf der Unterseite des Substrats 32 für die Durchprüfung hergestellt. Die Bestimmung des Musters von Anschlußkontakten erfordert jedoch keinen Kontakt zu der Schaltung in dem Substrat, da die Vorrichtung und deren Arbeiten ausschließlich von einem Kurzschluß zwischen benachbarten Blattfederelementen abhängt. Das system kann auch abgewandelt werden. Beispielsweise kann das Substrat in X- und Y-Richtung festgelegt werden, und der Abtastkopf 30 kann, falls erwünscht, vom Ort eines Anschlußkontaktes zum Ort des nächsten Anschlußkontaktes bewegt werden. Außerdem kann die Abtastsonde auch für andere Zwecke benutzt werden, d. h. zum Feststellen, ob Leitungszüge oder Leitungsmuster vorhanden sind oder nicht.

**Patentansprüche**

1. Abfühlvorrichtung zur Bestimmung der Ortskoordinaten in X- und Y-Richtung einer Gruppe von elektrisch leitenden Punkten auf der Oberfläche eines isolierenden Substrats, mit einer Substrathalterung, dadurch gekennzeichnet, daß über einem als Substrathalterung dienenden Tisch mindestens zwei Abtastsonden (24, 26, 28) angeordnet sind, die jeweils aus einer Anzahl langgestreckter biegsamer, flacher übereinander gestapelter, gegeneinander isolierter Blattfederelemente (42) bestehen, deren Enden in einer parallel zur Oberfläche des Substrats (32) verlaufenden Ebene liegen, wobei die Dicke von mindestens zwei dieser Elemente insgesamt kleiner ist als die Breite eines der leitenden Punkte (37), daß dabei die erste Abtastsonde (24) derart angeordent ist, daß die Nebenachse (45) der Elemente (42) senkrecht zur X-Richtung verläuft, daß die zweite Abtastsonde (26) derart angeordnet ist, daß die Nebenachse (45) der Elemente senkrecht zur Y-Richtung verläuft, daß ferner die Abtastsonden in Z-Richtung in Eingriff mit dem Substrat (32) absenkbar sind und daß die Abtastsonden mit ihren einzelnen Elementen an einer Auswerteschaltung angeschlossen sind, durch die feststellbar ist, welche und wie viele Blattfederelemente durch den Kontakt mit dem leitenden Punkt kurzgeschlossen sind, wodurch über diese beiden Abtastsonden der Ort ausgewählter leitender Punkte auf der Oberfläche des Substrats feststellbar ist.

2. Vorrichtung nach Anspruch 1, dadurch gekennzeichnet, daß eine dritte Abtastsonde (28) zur Feststellung der Winkellage der leitenden Punkte vorgesehen ist.

3. Vorrichtung nach Anspruch 2, dadurch gekennzeichnet, daß die dritte Abtastsonde (28) mit Abstand von der ersten Abtastsonde (24) derart angeordnet ist, daß die Nebenachse (45) der Blattfederelemente (42) senkrecht zur X-Richtung liegen.

4. Vorrichtung nach Anspruch 1, dadurch gekennzeichnet, daß jede Abtastsonde aus einer Grundplatte (40) und einer Anzahl biegsamer langgestreckter, flacher Blattfederelemente (42) besteht, die auf der Grundplatte befestigt und gegeneinander isoliert sind, daß die Endabschnitte (46) dieser Blattfederelemente in einer Ebene enden, die im wesentlichen senkrecht zur Hauptachse (43) der Blattfederelemente verläuft und daß dabei die Blattfederelemente übereinander derart eingespannt sind, daß jedes weitere Blattfederelement eine größere Krümmung aufweist, als das vorliegende Blattfederelement.

5. Vorrichtung nach Anspruch 4, dadurch gekennzeichnet, daß die Abtastsonden Blattfederelemente (42) mit einem biegsamen Mittelabschnitt (54) mit das Ende dieses Mittelabschnitts festlegenden Anschlagkanten (50, 52) aufweisen und

daß die Grundplatte Anschlagflächen (58, 59) aufweist, an denen die Anschlagkanten (50, 52) anliegen.

6. Vorrichtung nach Anspruch 5, dadurch gekennzeichnet, daß eine der Anschlagflächen (58) der Grundplatte geneigt ist und

daß der Abstand der beiden Anschlagflächen an jeder Stelle kleiner ist als die Länge des Mittelabschnitts (54) des Blattfederelemente (42)

**Claims**

1. Sensing apparatus for determining the coordinates in X and Y directions of a set of electrically conductive features on the surface of an insulating substrate, with a substrate support, characterized in that over a substrate support table at least two sensor heads (24, 26, 28) are arranged each consisting of a number of elongated, flexible, flat, laminated sensing blade elements (42) insulated from each other, whose ends are in a plane parallel to the surface of the substrate (32), the thickness of at least two of these elements being less than the width of one of the conductive features (37), that the first sensor head (24) is arranged in such a manner that the minor axis (45) of the elements (24) in oriented orthogonally to the X direction, that the second sensor head (26) is arranged is such a manner that the minor axis (45) of the elements in oriented orthogonally to the Y direction, that furthermore the sensor heads are movable in Z direction into engagement with the substrate (32), and that the sensor heads with their individual elements are connected to an evaluator circuit determining which and how many blade elements are electrically shorted through the contact with the conductive feature, so that via these two sensor heads the location of selected conductive features on the substrate surface can be determined.

2. Apparatus as claimed in claim 1, characterized in that a third sensor head (28) for determining the angular orientation of the conductive features in provided.

3. Apparatus as claimed in claim 2, characterized in that the third sensor head (28) in spaced from the first sensor head (24) in such a manner that the minor axis (45) of the blade elements (42) is oriented orthogonally to the X direction.

4. Apparatus as claimed in claim 1, characterized in that each sensor head consists of a mounting base (40) and of a number of flexible, elongated, flat blade elements (42) that are fixed on the mounting base and electrically insulated from each other, that the end portions (46) of these blade elements terminate in a plane that is substantially orthogonal to the main axis (43) of the blade elements, and that the blade elements are held one over the other in such a manner that each successive blade element shows a greater bow than the preceding blade element.

5. Apparatus as claimed in claim 4, characterized in that the sensor heads comprise blade elements (42) with a flexible intermediate portion (54) with abutment means (50, 52) defining the end of this intermediate portion, and that the mounting plate comprises abutment surfaces (58, 59) engaging with abutment means (50, 52).

6. Apparatus as claimed in claim 5, characterized in that one of the abutment surfaces (58) of the mounting base is inclined, and that the distance between the two abutment surfaces at each location is less than the length of the intermediate portion (54) of the blade elements (42).

**Revendications**

1. Dispositif de détection pour déterminer les coordonnées dans la direction X-Y d'un ensemble d'éléments électriquement conducteurs situés sur la surface d'un substrat isolant muni d'un support de substrat, caractérisé en ce que sur une table servant de support de substrat sont disposées au moins deux sondes de détection (24, 26, 28) comportant chacune un certain nombre de lames (42) allongées, souples, plates, laminées, isolées entre elles, et dont les extrémités sont situées dans un plan parallèle à la surface du substrat (32), l'épaisseur d'au moins deux de ces lames étant plus petite que la largeur d'un de ces éléments conducteurs (37), en ce que la première sonde de détection (24) est disposée de sorte que l'axe secondaire (45) des lames (42) soit orthogonal à la direction X, et la seconde sonde de détection (26) est disposée de sorte que l'axe secondaire (45) des lames (42) soit orthogonal à la direction Y, en ce qu'en outre les sondes de détection peuvent être abaissées dans la direction Z pour entrer en contact avec le substrat (32) et en ce que les sondes de détection, avec leurs différentes lames, sont connectées à un circuit d'évaluation qui détermine combien de lames et quelles lames ont été court-circuitées par le contact avec l'élément conducteur, l'emplacement des éléments électriquement conducteurs sur la surface du substrat pouvant être déterminé à l'aide de ces deux sondes de détection.

2. Dispositif selon la revendication 1, caractérisé en ce qu'une troisième sonde de détection (28) est prévue pour déterminer l'orientation angulaire des éléments conducteurs.

3. Dispositif selon la revendication 2, caractérisé en ce que la troisième sonde de détection (28) est espacée de la première sonde de détection (24) de telle sorte que l'axe secondaire (45) des lames (42) soit orthogonal à la direction X.

4. Dispositif selon la revendication 1, caractérisé en ce que chaque sonde de détection comporte une plaque de base (40) et un certain nombre de lames (42) souples, allongées, plates, qui sont fixées sur la plaque de base et isolées entre elles, en ce que les parties extrêmes (46) de ces lames aboutissent dans un plan qui est essentiellement orthogonal à l'axe principal (43) des lames et en ce que les lames sont disposées les unes sur les autres de sorte que chaque lame d'une série a une courbure plus grande que la lame précédente.

5. Dispositif selon la revendication 4, caractérisé en ce que les sondes de détection comportent des lames (42) ayant une partie médiane souple (54) avec des butées (50, 52) qui délimitent cette partie, et que la plaque de base est munie de surfaces de butées (58, 59) contre lesquelles s'appuient les butées (50, 52).

6. Dispositif selon la revendication 5, caractérisé en ce que l'une des surfaces de butée (58) de la plaque de base est inclinée et que la distance des deux surfaces de butée à chaque emplacement est plus petite que la longueur de la partie médiane (54) des lames (42).

**FIG. 1**

FIG. 2

FIG. 2A

FIG. 2B

FIG. 3

3

FIG. 4

FIG. 4A